# EUROPEAN PATENT APPLICATION

(11) **EP 1 167 572 A2**
(43) Date of publication of application: **02.01.2002**
(21) Application number: 01305356.6
(22) Date of filing: 20.06.2001
(51) Int. Cl.: C23C 16/455, H01J 37/32, H01L 21/00

(54) **Lid assembly for a semiconductor processing chamber**

(30) Priority: 22.06.2000 US 602657
(71) Applicant: Applied Materials, Inc., Santa Clara, California 95054 (US)
(72) Inventor: Vo, Bevan, Santa Clara, California 95051 (US); Umotoy, Salvador P., Antioch, California 94509 (US); Trinh, Son N., Cupertino, California 95014 (US); Littau, Karl A., Palo Alto, California (US); Kao, Chien-Teh, Sunnyvale, California 94086 (US); Lai, Ken Kaung, Milpitas, California 95035 (US); Zheng, Bo, San Jose, California 95129 (US); Jian, Ping, San Jose, California 95148 (US)
(74) Representative: Bayliss, Geoffrey Cyril

(57) **Abstract**

A lid assembly for distributing gases in a semiconductor process chamber (202). In one embodiment, a lid assembly (210) comprising a perforated center portion (218), a mounting portion (1202) circumscribing the perforated center portion and a plurality of bosses (1210) extending from the mounting portion each having a hole (1306) disposed therethrough is provided. Another embodiment of the invention provides a showerhead (218) that includes a mounting portion having a first side (1206) circumscribing a perforated center portion. A ring extends from the first side of the mounting portion. A plurality of mounting holes are disposed in the mounting portion radially to either side of the ring. The showerhead provides controlled thermal transfer between the showerhead and chamber lid resulting in less deposition on the showerhead.

## Description

This application is related to contemporaneously filed United States Patent Application Serial No. 09/603,117, which is hereby incorporated by reference in its entirety. US 09/603,117 has a corresponding European Application No. 01305218.8.

The invention relates generally to an apparatus for the distribution of one or more gases within a process chamber.

Integrated circuits have evolved into complex devices that can include millions of transistors, capacitors and resistors on a single chip. The evolution of chip designs continually requires faster circuitry and greater circuit density that demand increasingly precise fabrication processes. One fabrication process frequently used is chemical vapor deposition (CVD).

Chemical vapor deposition is generally employed to deposit a thin film on a substrate or semiconductor wafer. Chemical vapor deposition is generally accomplished by introducing a precursor gas into a vacuum chamber. The precursor gas is typically directed through a showerhead situated near the top of the chamber. The precursor gas reacts to form a layer of material on a surface of the substrate that is positioned on a heated substrate support. Volatile by-products produced during the reaction are pumped from the chamber through an exhaust system.

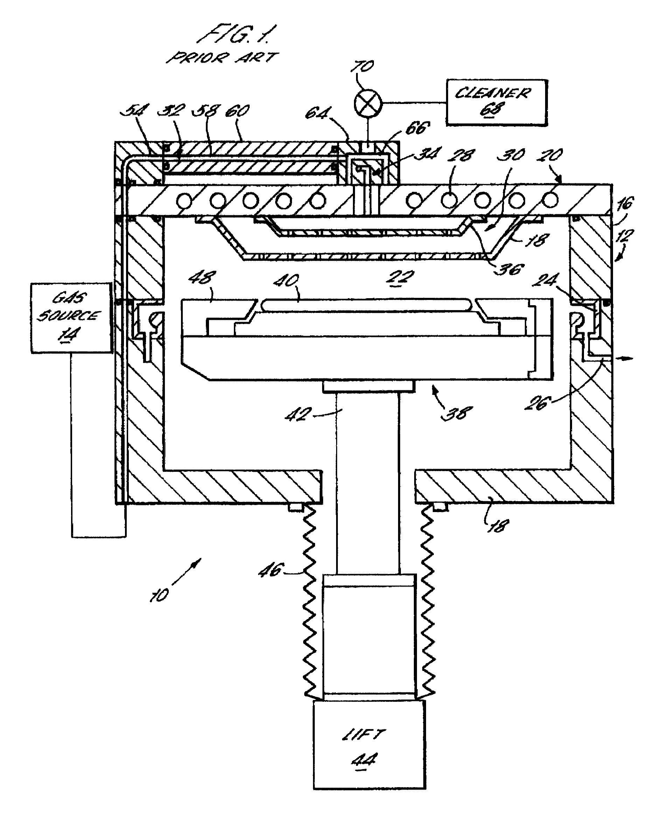

Fig. 1 depicts an exemplary chemical vapor deposition system 10. The system 10 generally includes a chamber 12 coupled to a gas source 14. The chamber 12 has walls 16, a bottom 18 and a lid assembly 20 that define a process volume 22. The walls 16 and bottom 18 are typically fabricated from a unitary block of aluminum. The chamber 12 contains a pumping ring 24 that couples the process volume 22 to an exhaust port 26 and other various pumping components not shown.

A heated support assembly 38 is centrally disposed within the chamber 12. The support assembly 38 supports a substrate 40 during processing. The support assembly 38 generally is fabricated from aluminum, ceramic or a combination of aluminum and ceramic, and typically includes a vacuum port and at least one heating element or embedded electrode. The vacuum port is used to apply a vacuum between the substrate 40 and substrate support 38, securing the substrate to the substrate support during processing. The electrode is coupled to a power source 30, heating the substrate support 38 and substrate 40 positioned thereon to a predetermined temperature. The process volume 22 is typically accessed through a port (not shown) in the walls 16 to facilitate movement of the substrate 40 into and out of the chamber 12.

Generally, the support assembly 38 is coupled to a stem 42. The stem 42 provides a conduit for electrical leads, vacuum and gas supply lines between the support assembly 38 and other components of the system 10. The stem 42 couples the support assembly 38 to a lift system 44 that moves the support assembly 38 between an elevated position (as shown) and a lowered position. Bellows 46 provides a vacuum seal between the process volume 22 and the atmosphere outside the chamber 12 while facilitating the movement of the support assembly 38. Lift pins and the associated mechanisms have been omitted for clarity.

The support assembly 38 additionally supports a purge ring 48. The purge ring 48 is annular in form and is typically comprised of ceramic. Generally, the purge ring 48 prevents deposition at the edge of the substrate 40, a process specification to prevent tungsten from peeling off the substrate during subsequent processing. Optionally, a purge gas is supplied between the purge ring 48 and the support assembly 38 to assist in preventing deposition at the substrate's edge. An example of a purge ring is described in United States Patent Application Serial 09/459,313, filed December 10, 1999, by Yudovsky et al., which is hereby incorporated by reference.

The lid assembly 20 is supported by the walls 16 and can be removed to facilitate service to the chamber 12. The lid assembly 20 is generally comprised of aluminum and may additionally contain heat transfer fluid channels 28 formed therein. The channels 28 are coupled to a fluid source (not shown) that flows a heat transfer fluid through the lid assembly 20. The channels 28 with the fluid flowing therethrough regulate the temperature of the lid assembly 20.

A mixing block 34 is disposed in the lid assembly 20. The mixing block 34 is coupled to the gas source 14 such that process and other gases may be introduced to the process volume 22 by passing through the mixing block 34, a blocker plate 36 and a showerhead 18. The mixing block 34 is additionally coupled to a cleaner 68 such as a remote NF₃ plasma microwave that generally provides a cleaning agent such as disassociated fluorine to the chamber. The cleaning agent is typically used to etch away unwanted deposits within the chamber 12. A shut off valve 70 is disposed between the cleaner 68 and the mixing block 34.

The showerhead 18 is generally coupled to an interior side of the lid assembly 20 and defines a plenum 30 therebetween. A perforated blocker plate 36 may optionally be disposed in the plenum 30 between the showerhead 18 and lid assembly 20. Gases (*i.e.,* process and other gases) that enter the chamber 12 through the mixing block 34 are first diffused by the blocker plate 36 as the gases fill the plenum 30 behind the showerhead 18. The gases then pass through the showerhead 18 and into the chamber 12. The plenum 30, blocker plate 36 and showerhead 18 are configured to provide a uniform flow of gases passing through the showerhead 18 into the chamber 12. Such uniformity of gas flow is desirable to promote uniform deposition on the substrate 40.

Process and other gases are transferred from the gas source 14 to the mixing block 34 through a segmented passage 32 that is routed through a series of chamber components. Typically, the gases from the gas source 14 are first routed through a gas panel (not shown) that controls flow rates and pressures of the gases entering the chamber 12. The gases are then are routed through a first segment 50 of the passage 32 that is disposed in the chamber wall 16. The chamber wall 16 thermally conditions the gases flowing through the first segment 50.

The first segment 50 is coupled to a second segment 52 that is disposed through the lid assembly 20. The second segment 52 is coupled to a third segment 54 that is disposed in a elbow block 56 disposed on top of the lid assembly 20. The third segment 54 of the passage 32 is coupled to a fourth segment 58 that is disposed in a feed through 60. The fourth segment 58 is coupled to a fifth segment 66 that is formed within a housing 64. Generally, the feed through 60 is elevated above the lid assembly 20, suspended between the elbow block 56 and the housing 64. The union of each segment 50, 52, 54, 58 and 66 is sealed by an o-ring. The o-rings confines the process and other gases within the passage 32.

Generally, the number of o-rings and components through which the passage 32 is routed is disadvantageous for a number of reasons. First, the number components including spares needed to be available for maintenance purposes is high. The number of o-rings used throughout the passage 32 creates a high probability of seal damage during assembly that may compromise the o-ring (*i*.*e*., develop a leak). Additionally, the components through which the passage 32 is disposed must be manufactured to tight tolerances to minimize the tolerance stack of the components. For example, the addition of tolerances of the components containing the passage 32 (*e*.*g*., tolerance stack) causes the overall length of the passage 32 to have a wide tolerance range. This wide tolerance range is typically much greater than the standard recommended tolerances for o-ring grooves that are designed to compress the o-ring to a specified amount. Thus, the high tolerance stack may cause the o-rings disposed between components to be over compressed, damaging the o-ring, or under compressed wherein the o-ring is not properly sealed. The large number of components requiring tight tolerances increases the cost of manufacturing, assembling and servicing the process system.

Therefore, there is a need for a lid assembly that minimizes the number of components used to deliver gases to a chemical vapor deposition chamber.

One aspect of the invention generally provides a lid assembly for distributing gases in a semiconductor process chamber. In one embodiment, a lid assembly includes a first plate connected to a second plate and having a channel formed therebetween. The first plate has at least one hole disposed therethrough. The channel is coupled to the at least one hole.

Another embodiment of the invention provides a lid assembly that includes a first plate having at least a first hole disposed partially therethrough. An aperture is disposed through the first plate. At least a first passage is disposed in the first plate. The passage fluidly couples the first hole and the aperture.

The teachings of the present invention can be readily understood by considering the following detailed description in conjunction with the accompanying drawings, in which:
Fig. 1 is a schematic sectional view of a processing chamber of the prior art;
Fig. 2 is a schematic sectional view of a processing chamber depicting one embodiment of a lid assembly;
Fig. 3 is a bottom plan view of a lower plate of the lid assembly of Fig. 2;
Fig. 4 is a top plan view of the lower plate of Fig. 3;
Fig. 5 is a bottom plan view of an upper plate of the lid assembly of Fig. 2;
Fig. 6A is a cross sectional view of the upper plate taken along section line 6A--6A of Fig. 2;
Fig. 6B is a cross sectional view of a portion of the upper plate taken along section line 6B--6B of Fig. 6A;
Fig. 7 is a top plan view of the upper plate of Fig. 5;
Fig. 8 is a cross sectional view of one embodiment of a mixing block taken along section line 8--8 of Fig. 2;
Fig. 9 is a cross sectional view of the mixing block taken along section line 9--9 of Fig. 8;
Fig. 10 is a cross sectional view of one embodiment of an adaptor;
Fig. 11A is a cross sectional view of a portion of another embodiment of a lid assembly;
Fig. 11B is a bottom plan view of the a portion of the lid assembly of Fig. 11A;
Fig. 12 is a cross sectional view of one embodiment of a showerhead taken along section line 12--12 of Fig. 2; and
Fig. 13 depicts a cross sectional view of the showerhead taken along section line 13--13 of Fig. 12.

To facilitate understanding, identical reference numerals have been used, where possible, to designate identical elements that are common to the figures.

The present invention generally provides a processing system and a showerhead that are advantageous for the deposition of tungsten films. The invention is illustratively described below in reference to a chemical vapor deposition system, such as a WxZ™ metal chemical vapor deposition (MCVD) system, available from Applied Materials, Inc., of Santa Clara, California. However, it should be understood that the invention has utility in other semiconductor processing system configurations such as physical vapor deposition systems, chemical vapor deposition systems, etch systems and any other system in which dispensing a gas through a lid assembly into a processing chamber is desired.

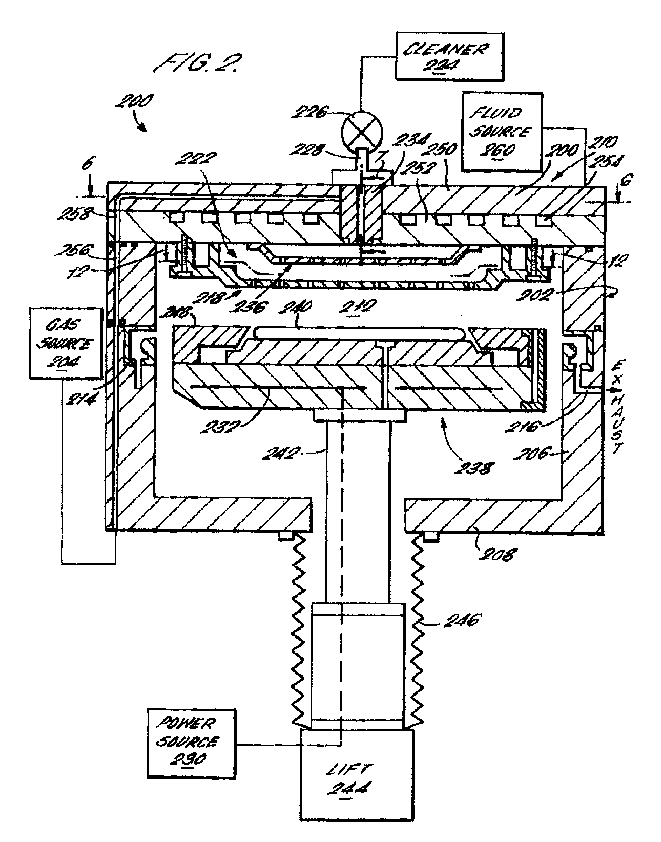

Fig. 2 is a cross sectional view of one embodiment of a chemical vapor deposition system 200. The system generally includes a chamber 202 coupled to a gas source 204. The chamber 202 has walls 206, a bottom 208 and a lid assembly 210 that define a process volume 212. The walls 206 and bottom 208 are typically fabricated from a unitary block of aluminum. The chamber 200 contains a pumping ring 214 that couples the process volume 212 to an exhaust port 216 (and other various pumping components not shown).

A heated support assembly 238 is centrally disposed within the chamber 202. The support assembly 238 supports a substrate 240 during processing. The support assembly 238 generally is fabricated from aluminum or ceramic and typically includes a vacuum port and at least one embedded electrode 232. The vacuum port is used to apply a vacuum between the substrate 240 and substrate support 238, securing the substrate to the substrate support during processing. The electrode 232 is coupled to a power source 230, heating the substrate support 238 and substrate 240 positioned thereon to a predetermined temperature. The process volume 212 is typically accessed through a port (not shown) in walls 206 to facilitate transfer of the substrate 240 into and out of the chamber 202. Generally, the support assembly 238 is coupled to a stem 242. The stem 242 provides a conduit for electrical leads, vacuum and gas supply lines between the support assembly 238 and other components of the system 200. The stem 242 couples the support assembly 238 to a lift system 244 that moves the support assembly 238 between an elevated position (as shown) and a lowered position. Bellows 246 provides a vacuum seal between the process volume 212 and the atmosphere outside the chamber 202 while facilitating the movement of the support assembly 238. Lift pins and the associated mechanisms have been omitted for clarity.

The support assembly 238 additionally supports a purge ring 248. The purge ring 248 is annular in form (or otherwise conformed to the shape of the substrate being processed) and is typically comprised of ceramic. Generally, the purge ring 248 prevents deposition at the edge of the substrate 240. Optionally, a purge gas is supplied between the purge ring 248 and the support assembly 238 to assist in preventing deposition at the substrate edge. An example of such a support assembly 238 is disclosed in United States Patent Application Serial No. 09/504,288 (attorney docket no. 4501-P1), filed 15 February 2000, (EP 01301314.9) which is hereby incorporated by reference in its entirety.

The lid assembly 210 is supported by the walls 206 and can be removed to facilitate service of the chamber 202. The lid assembly 210 generally includes a showerhead 218, a blocker plate 236, a lid 220 and a mixing block 234. The lid assembly 210 is coupled to a fluid source 260 that provides a thermally regulated heat transfer fluid such as water to maintain the lid assembly 210 at a predetermined temperature. The mixing block 234 is centrally disposed in the lid 220. The mixing block 234 is coupled to the gas source 204 via a passage 258 in the lid 220. Process and other gases may be introduced to the process volume 212 from the gas source 204 by passing through one or more passages 258 in the lid 220 to the mixing block 234 that flows the gases to a showerhead 218. Optionally, the gases flowing from the gas source may be routed through one or more passages 256 in the chamber walls 206 to thermally condition the gases before entering the passages 258 in the lid 220. Optionally, the passages 258 and 256 may be routed through other chambers 202 components or externally from the chamber 202. Additionally, the mixing block 234 is coupled to a cleaner 224 that provides a cleaning agent such as disassociated fluorine to the process volume 212 during cleaning procedures. A shut-off valve 226 is positioned between the cleaner 224 and mixing block 234 to control the flow of the cleaning agent. The valve 226 is connected to the mixing block 234 by an adapter 228 that minimizes the volume of the passages between the mixing block 234 and the valve 226.

The showerhead 218 is generally coupled to a side of the lid 220 that is exposed to the process volume 212. The showerhead 218 and the lid 220 define a plenum 222 therebetween. The perforated blocker plate 236 may optionally be disposed in the plenum 222 between the showerhead 218 and lid 220. Gases (*i*.*e*., process and other gases) that enter the chamber 202 through the mixing block 234 are first diffused by the blocker plate 236 as the gases fill the plenum 222 behind the showerhead 218. The gases then pass through the showerhead 218 and into the chamber 202. The plenum 222, blocker plate 236 and showerhead 218 are configured to provide a uniform flow of gases passing through the showerhead 218 into the chamber 202. Such uniformity of gas flow is desirable to promote uniform deposition on the substrate 240.

The lid 220 is comprised of a first (upper) plate 250 and a second (lower) plate 252 having a fluid passage 254 formed therebetween. The upper plate 250 and lower plate 252 are typically comprised of aluminum. The upper plate 250 and lower plate 252 are coupled together such that the fluid passage 254 is leak-tight. For example, the fluid passage 254 may be leak-tight at 200 psi for 5 minutes. The plates may be coupled by fasteners, adhesives, fusing, sintering, brazing, riveting, welding, clamping and by other means which maintain the integrity of the passage 254. In one embodiment, the plates 250 and 252 are brazed by melting a patterned foil of aluminum therebetween. To enhance the integrity of the joint, the plates 250 and 252 should comprise similar materials, having, for example similar coefficients of thermal expansion, to minimize differences in thermal expansion.

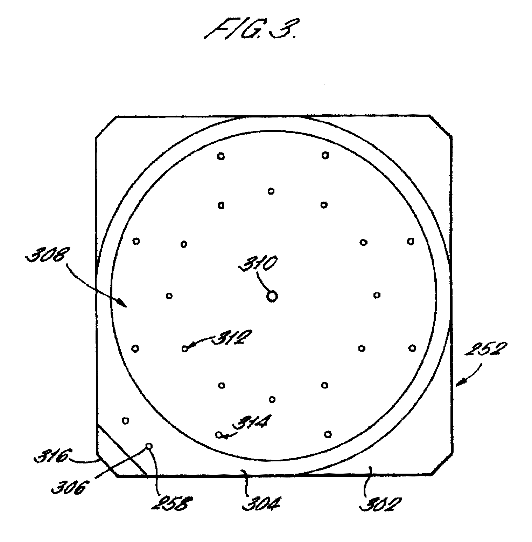

Fig. 3 is a bottom plan view of the lower plate 252 of the lid 220 depicting a bottom side 302. The lower plate 252 is generally rectangular in shape. The lower plate 252 includes a first surface 304 that projects from the bottom side 302. The first surface 304 is generally annular in form and is configured to sit atop and seal with the chamber walls 206. The seal is typically provided by an o-ring disposed in the chamber walls 206. However, other seals or sealing methods may be used. A first portion 306 of the one or more gas passages 258 (two are shown in Fig. 3) is disposed through the first surface 304 of the lower plate 252. Generally, the first portions 306 of the passages 258 are positioned near a corner 316 of the lower plate 252 and align with the passages 256 disposed in the chamber walls 206 (see Fig. 1).

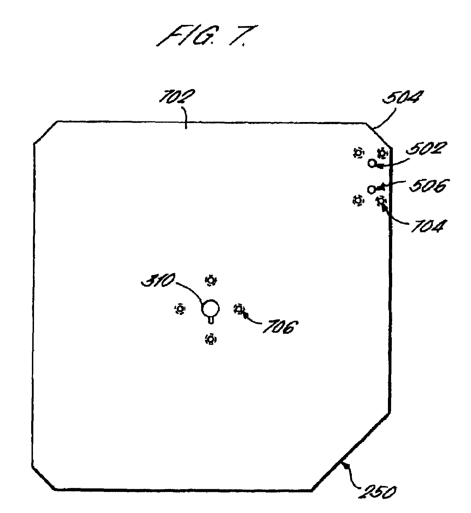

The bottom side 302 additionally has a second surface 308 that is exposed to the process volume 212. The second surface 308 is typically recessed in relation to the first surface 304. The second surface 308 includes an aperture 310 disposed through the lower plate 252. The aperture 310 is generally located in the center of the second surface 308 and extends through the upper plate 250 as described below with reference to Fig. 7. A first plurality of mounting holes 312 for securing the blocker plate 236 and a second plurality of mounting holes 314 for securing the showerhead 218 are disposed in the second surface 308. Generally, the first plurality of mounting holes 312 are disposed radially inward of the second plurality of mounting holes 314.

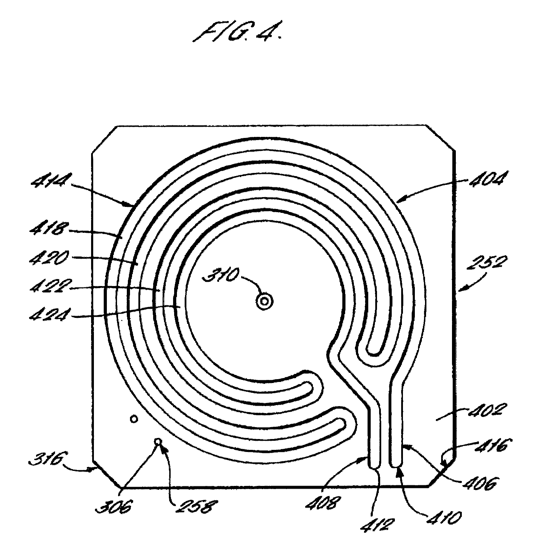

Fig. 4 is a top plan view of the lower plate 252 of the lid 220 depicting a top side 402. The top side 402 typically includes a channel 404 at least partially formed therein. The channel 404 generally provides a passage for heat transfer fluid to be circulated through the lid 220 from the fluid source 260. Generally, the lid 220 is maintained at about 65 degrees Celsius during processing.

Optionally, a portion or all of channel 404 may be disposed completely in the upper plate 250. Alternatively, some or all of the channel 404 may be disposed at least partially in the lower plate 252 and at least partially in the upper plate 250 or various combinations thereof. Common to these embodiments is that the mating of the surfaces of the upper and lower plates 250, 252 defines the channels 404 and confines the travel of fluids thereto.

In one embodiment, the channel 404 is formed in the top side 402. The channel 404 includes a first portion 406, a second portion 408 and a middle portion 414. The first portion 406 has an end 410 near a corner 416. The corner 416 may be adjacent to the corner 316. The second portion 408 has an end 412 positioned adjacent to the end 410.

The middle portion 414 of the channel 402 is generally configured to substantially circumscribe the aperture 310. The middle portion 414 may include a plurality of passes or loops. For example, in one embodiment, the middle portion 414 has a first pass 418 disposed about the aperture 310 that connects the first portion 406 to a second pass 420 that is disposed radially inwards of the first pass 419. A third pass 422 is disposed radially inwards of the second pass 420 and couples the second pass 420 to a fourth pass 424. The fourth pass 424 is disposed radially inwards of the third pass 422 and is coupled to the second end 408. The concentric passes comprising the middle portion 414 may include additional or fewer passes.

The multiple passes comprising the channel 404 provided uniform temperature control of the lid 220. The multiple passes enhances the surface area of the channel 404 that in turn promotes heat transfer between the lid 220 and the fluid flowing therein. One skilled in the art will recognize that various configurations, including those wherein the channel 404 or passages in fluid communication therewith are not concentric to the aperture 310, may be utilized to obtain the benefit of the invention.

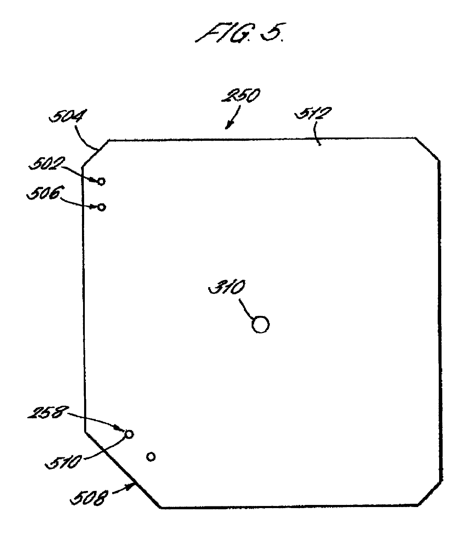

Fig. 5 depicts a bottom view of the upper plate 250 having a bottom side 512. The upper plate 250 includes the aperture 310, a first hole 502 and a second hole 506. The holes 502, 506 are generally positioned near a corner 504 of the upper plate 250. When the upper and lower plates 250, 252 are coupled having their respective corners 504 and 416 orientated one atop the other, the first hole 502 aligns with the end 410 of the first portion 406 of the channel 404 and the second hole 506 aligns with the end 412 of the second portion 408 of the channel 404, thus allowing fluid flowing in the channel 404 to be routed through the upper plate 250.

The upper plate 250 additionally has a second portion 510 of the passages 258 disposed partially through the upper plate 250. The second portions 510 of the passages 258 are generally positioned adjacent each other and proximate to a corner 508. When the upper and lower plates 250, 252 are coupled as described above, the second portion 510 of the passage 258 disposed in the upper plate 250 aligns with the first portion of the passage 258 disposed in the lower plate 252, thus allowing gases flowing through the chamber walls 206 from the gas source to be routed through the lower plate 252 and into the upper plate 250.

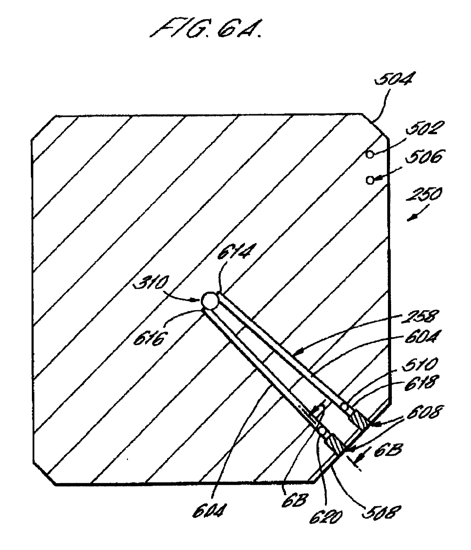

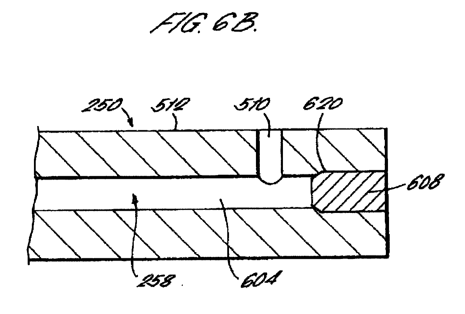

Figs. 6A and 6B depicts the upper plate 250 in cross section. The passages 258 additionally include a third portion 602 disposed in the upper plate 250 between the aperture 310 and the second portion 510 of the passages 258. Generally, the third portion 602 is fabricated by forming a hole, such as by drilling, from or proximate the corner 508 of the upper plate 250 and the aperture 606. The third portion 602 of one passage 258 and a third portion 604 of another passage 258 shown in Fig. 6A each include a respective end 614, 616 that breaks into the aperture 310, fluidly coupling the third portions 602, 604 with the aperture 310. In one embodiment, the ends 614 and 616 are positioned on opposite sides of the aperture's 310 diameter.

The passages 602, 604 include another end 618 and 620 that are respectively disposed opposite the ends 614, 616. The ends 618, 620 exit the upper plate 250 at the corner 508 and are sealed off by a plug 608 inserted therein. The plug 608 is press fit brazed, welded or fastened in place and may optionally incorporate an o-ring or other seal. The plugs 608 provide a gas-tight seal between the passages formed by the passage portions 602, 604 and the exterior of the upper plate 250 (*i*.*e*., the environment surrounding the chamber 202). In one embodiment, the plug 608 and coupling of the plates 250, 252 seal the passage 258 to 1xE-9 sccs of helium at 3xE-8 Torr differential. An example of such a plug is a model no. PLGA2181020A, available from The Lee Company, Westbrook, Connecticut. The second portions 510 of the passages 258 intersect the passages 602, 604 near the corner 508 beyond the depth of the plug's insertion. (See Fig. 6B). This allows gases flowing through the second portion 510 to travel through the third portions 602, 604 and into the aperture 310.

Fig. 7 depicts a top plan view of the upper plate 250 having a top surface 702. The holes 502 and 506 exit the upper plate 250 through the top surface 702. Generally, a plurality of mounting holes 704 are positioned about the holes 502, 506 to secure a heat transfer fluid coupling (not shown) thereto. Alternatively, the holes 502, 506 may be threaded at the top surface 702 to accept fluid couplings directly. The top surface additionally includes a second plurality of mounting holes 706 positioned about the aperture 310. The second plurality of mounting holes 706 secure the adapter 228 to the lid 220.

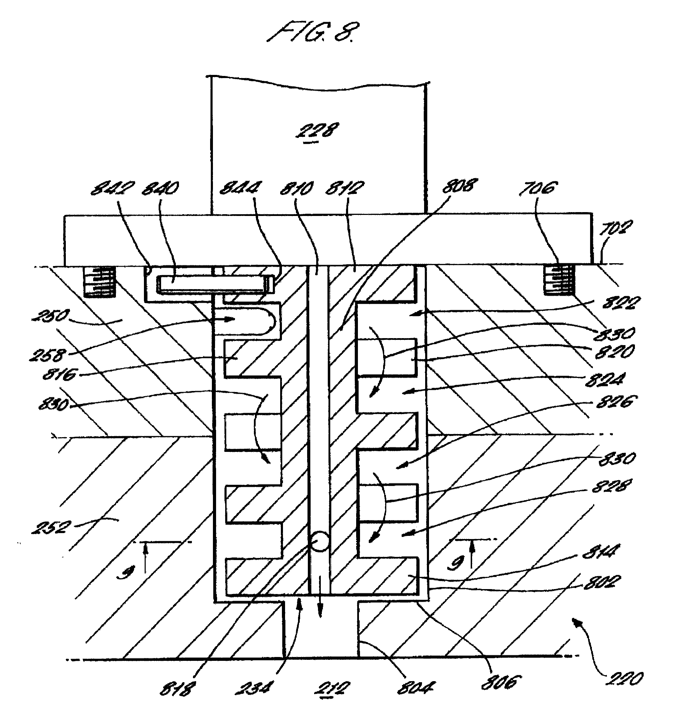

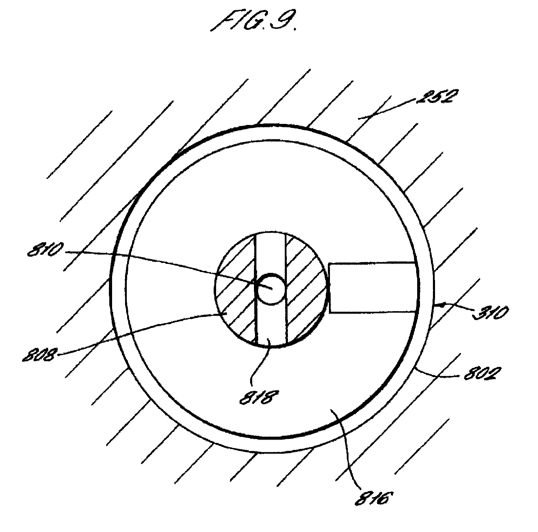

Figs. 8 and 9 are cross sectional views of one embodiment of the mixing block 234. Generally, the mixing block 234 is removably disposed in the aperture 310 that passes through the lid 220. In one embodiment, the aperture 310 includes a larger diameter portion 802 and a smaller diameter portion 804. The larger diameter portion 802 is large enough to accommodate the mixing block 234 therein. The smaller diameter portion 804 is typically positioned at least partially in the lower plate 252 and is in communication with the process volume 212. The change in diameter of the aperture 310 creates a ledge 806 that prevents the mixing block 234 from passing into the processing volume 212.

The mixing block 234 generally includes a body 808 having a center hole 810 disposed axially therethrough. The body 808 includes a first flanged end 812 and an opposing second flanged end 814. A plurality of flutes 816 extending from the body 808 are positioned between the first end 812 and the second end 814. Generally, the flutes 816 have a diameter substantially equal to the diameters of the first end 812 and the second end 814. The flute's diameter is selected such that minimal gases pass between the flute 816 and the larger diameter portion 802 of the aperture 310. Each flute 816 includes a cut-out 820 that couples a mixing volume (shown as 822, 824, 826 and 828 in Fig. 8) defined between adjacent flutes 816 (or a flute and one of the ends). A cross hole 818 is disposed through the body 808 and couples the mixing volume 828 defined adjacent the second end 814 with the center hole 810.

Process and other gases supplied from the gas source 224 enters the mixing volume 822 adjacent the first end 812 through the passages 258. The gases flow sequentially into the next mixing volumes 824, 826 by passing through the cut-outs 820 in the flutes 816 as illustrated by arrows 830 until the gases reach the mixing volume 828 adjacent the second end 814. The gases then flow through the cross hole 818 and into the center hole 810. The gases then flow out of the center hole 818 of the mixing block 234 and into the process volume 212. As the separate streams of gases passing through each passage 258 are combined in the mixing block 234, the turbulence created by the changes in flow direction *(i.e.,* static mixing) as the gases pass through the sequential mixing volumes thoroughly blend the gases into a homogeneous mixture. In one embodiment, the mixing block 234 includes three flutes 816 disposed between the first and second ends 812, 814. One skilled in the art will readily recognize that other configurations of mixing blocks may be utilized.

To prevent the mixing block 234 from rotating in the lid 220, the mixing block 234 includes a dowel pin 840 that interfaces with a slot 842 formed in the top surface 702 of the upper plate 250. The dowel pin 840 extends from a hole 844 disposed in the first end 812 of the mixing block 234. Alternative means for orienting and preventing rotation of the mixing block 234 may be utilized. For example, one of the plates comprising the lid 220 and the mixing block 234 may include mating geometry to orientate and prevent rotation, a key may be disposed between the lid 220 and the mixing block 234 or fasteners may be used.

During cleaning procedures, the cleaning agent is provided from the cleaner 224 to the process volume 212 via the adapter 228 and mixing block 234. The cleaning agent flows through the center hole 810 in the mixing block 234 into the process volume 212. To minimize the volume of cleaning agent trapped on the mixing block 234 side of the shut-off valve 226, the adapter 228 is configured to have a low internal volume.

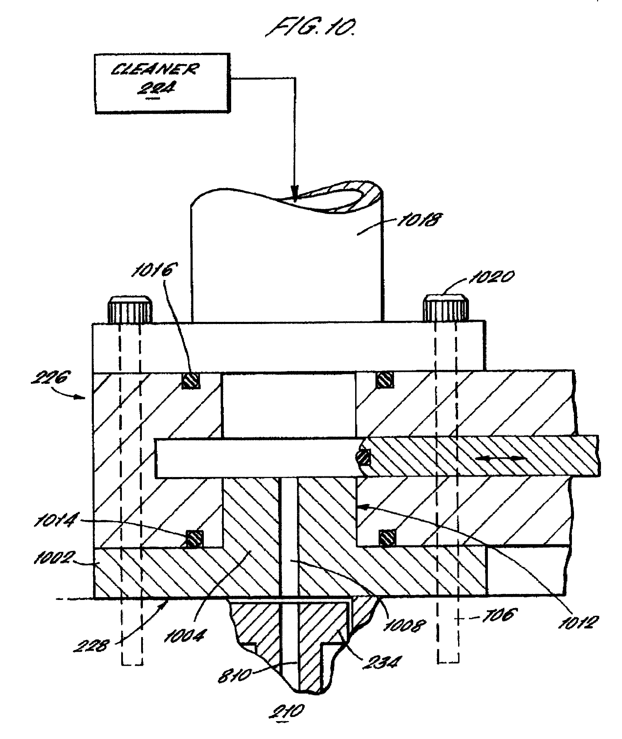

Fig. 10 depicts a cross sectional view of one embodiment of the adapter 228. The adapter 228 is generally disposed between a shut off valve 226 and the lid assembly 210. The adapter 228 includes a flange 1002 disposed at one end a body 1004. The body 1004 has a passage 1008 that allows gases from the cleaner 224 to pass through the valve 226 and into the center hole 810 of the mixing block 234. The passage 1006 has a diameter selected to minimize the internal volume between the valve 226 and the mixing block 234. The minimized volume diminishes cross contamination of other gases passing through the mixing block 234 and impedes deposition within the adapter 228 and on the valve 226.

In one embodiment, at least a portion of the body 1004 extends into an outlet port 1012 of the valve 226 to further decrease the volume downstream of the valve 226. The valve 226, depicted as a gate valve but may comprise other types of valves, is sandwiched between a coupling 1018 that connects process tubing to the cleaner 224 and the adapter 228. Generally, a pair of o-rings 1014 and 1016 seal the valve 226 between the coupling 1018 and the adapter 228. The o-rings 1014, 1016 are compressed by a plurality of fasteners 1020 that pass through the coupling 1018, valve 226 and adapter 228 and thread into the mounting holes 706 disposed in the lid assembly 210 thereby securing the adapter 228 and valve 226 to the lid assembly 210. The valve 226 and adapter 228 may be coupled to the lid assembly 210 in other configurations and by other methods.

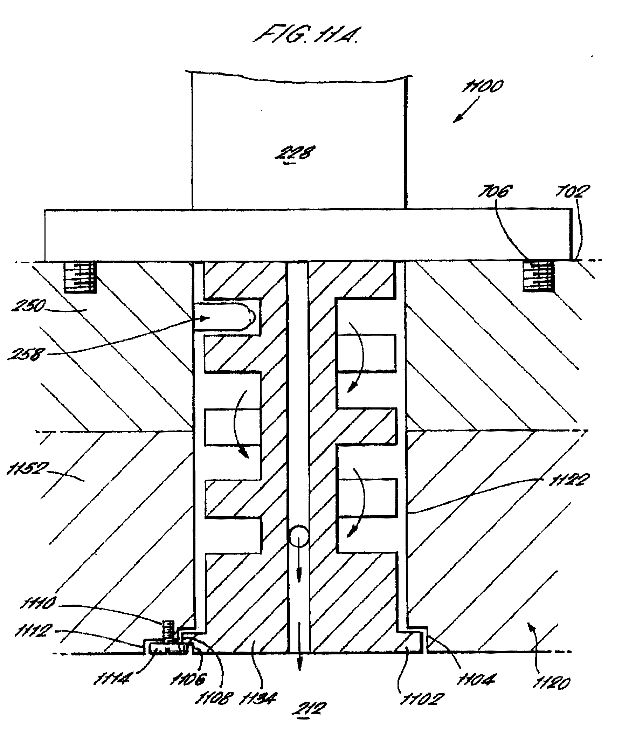

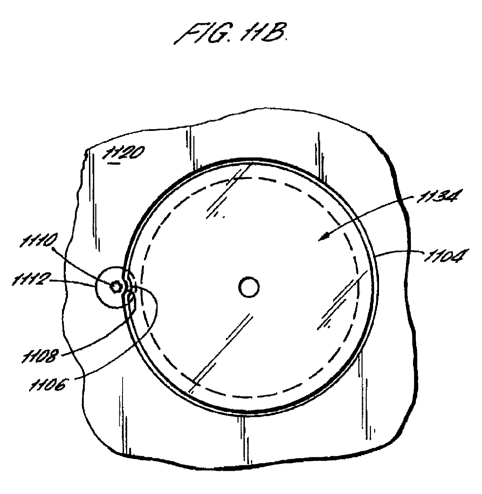

Figs. 11A and 11B depicts another embodiment of a lid assembly 1100 having a mixing block 1134. The lid assembly 1100 is substantially similar to the lid assembly 210 described with reference to Fig. 2-7. The lid assembly 1100 has a lid 1120 that includes an upper plate 250 and a lower plate 1152 having a channel (not shown) formed therebetween. An aperture 1122 is disposed through the upper and lower plates 250, 1152. The mixing block 1134 is disposed in the aperture 1122 and is configured substantially similar to the mixing block 234 described with reference to Figs. 8 and 9. The mixing block 1134 includes flange 1102 disposed at one end that seats within a counter bore 1104 formed in the lower plate 1152 co-axial with the aperture 1122. The flange 1102 of the mixing block 1134 has a semi-circular cut-out 1108 disposed in the perimeter of the expanded end 1102. The cut-out 1108 has a concentric counter bore 1106 disposed on the surface of the mixing block 1134 that is exposed to the process volume 212.

The lower plate 1152 has a threaded hole 1110 disposed proximate the counter bore 1104 concentric with the aperture 1122. The threaded hole 1110 includes a counter bore 1112 that partially breaks into the counter bore 1104.

When the mixing block 1134 is disposed in the aperture 1122, the portion of the lower plate 1152 surrounding the threaded hole 1110 mates with the cut-out 1108 disposed in the mixing block 1134, thus aligning and preventing rotation of the mixing block 1134 and lower plate 1152. A vented screw 1114 may be threaded into the threaded hole 1110 such that the screw's head projects partially into the counter bores 1106 and 1112 to retain the mixing block 1152 within the aperture 1122 and the lid 1120.

To remove the mixing block 1134, the lid assembly 1100 is moved into an open position (in relation to the chamber body not shown). The screw 1108 is removed, allowing the mixing block 1134 to be removed from the lid assembly 1100 without removing or disturbing the cleaner 224 or the associated hardware mounted on the exterior of the lid assembly 1100 such as the adapter 228 or shut off valve 226. Generally, the removal of the mixing block 1134 occurs after a showerhead and blocker plate (both not shown) have been removed for service or cleaning.

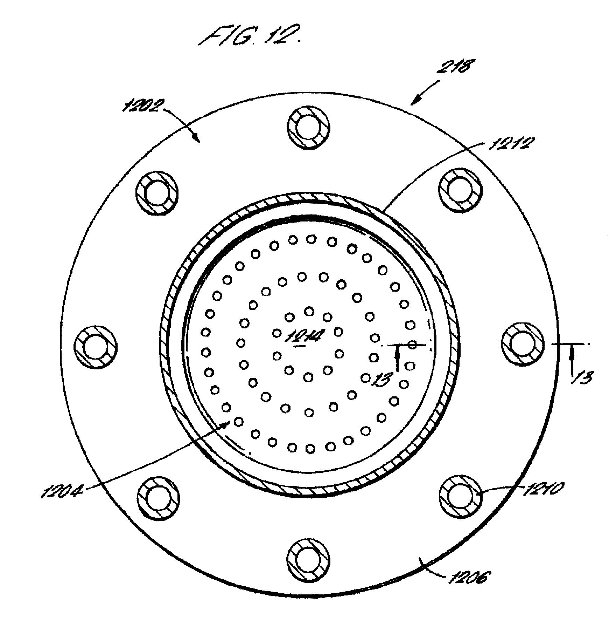

Fig. 12 is a cross sectional view of one embodiment of the showerhead 218 depicted in Fig. 2. The showerhead 218 is typically fabricated from aluminum. The showerhead 218 generally includes a mounting portion 1202 circumscribing a center portion 1204. The mounting portion 1202 includes a first side 1206 that has a plurality of bosses 1210 and a ring 1212 extending therefrom. Generally, at least two or more bosses 1210 may be utilized. The ring 1212, shown positioned radially inwards of the bosses 1210, may be position to either side of the bosses 1212. Alternatively, the bosses 1212 may be positioned on both sides of the ring 1212. The center portion 1204 has a perforated portion 1214 that permits fluid (*e.g.,* gas) passage through the showerhead 218.

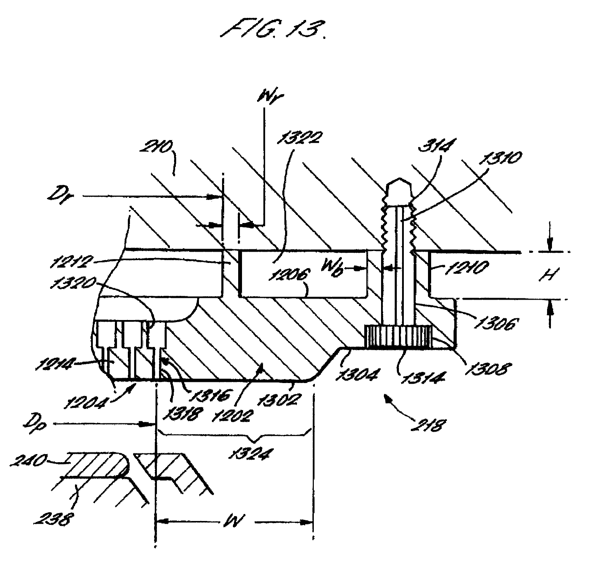

Fig. 13 depicts a portion of the showerhead 218 in cross section. The mounting portion 1202 generally includes a second side 1302 opposite the first side 1206. The second side 1302 has a flange 1304 disposed at the perimeter of the showerhead 218 that contains a plurality of mounting holes 1306 passing therethrough. Each hole 1306 passes through the flange 1304 and passes respectively through one of the bosses 1210 disposed on the first side 1206 of the showerhead 218. Each hole 1306 includes a counter bore 1308 disposed on the second side 1302 of the flange 1304. A mounting screw 1310 passes through the mounting hole 1306 and threads into the mating threaded hole 314 in the lid assembly 210. The counter bore 1308 accepted a head 1314 of the bolt 1310 such that the head 1314 is positioned flush with or slightly recessed from the second side 1302 of the flange 1304.

The boss 1210 and the ring 1212 extend from the second side 1206 of the showerhead 218 to a height "H" that maintains the second side 1206 of the mounting portion 1202 at a predetermined distance from the lid assembly 210 (i.e., a gap 1322). The boss 1210 has a wall thickness "W_{b}". The wall thickness W_{b} is configured to minimize the cross sectional area of the boss 1210. In one embodiment, the showerhead 218 includes eight bosses 1212 having a wall thickness of about 0.060 inches and a height of 0.250 inches positioned in a spaced-apart relation about the mounting portion 1202.

Typically, the bosses 1210 are positioned on a bolt circle having a diameter "D_{b}". The diameter D_{b} positions the mounting holes 1306 radially outwards of the mounting hole position found on showerheads used in conventional wafer processing systems. The outward location of the mounting holes 1306 minimizes turbulence of gases passing through the perforated portion 1214 by providing a smooth surface 1324 immediately outward and co-planar to the perforated portion 1214. In one embodiment, the surface 1324 has a width "W" of greater than about 0.25 inches, and preferably about 2.25 inches. Generally, prior art systems having mounting holes close to the perforated area do not provide the width required by the adjacent surface to minimize turbulence of gases flowing through the showerhead.

In one embodiment, the ring 1212 is positioned radially inwards of the boss 1210. The ring 1212 channels the process and other gases exiting the mixing block 234 and blocker plate 236 into the plenum 222 through the perforated portion 1214 of the showerhead 218 and into the chamber 202.

The ring 1212 has a diameter "Dᵣ". The diameter Dᵣ is generally selected to be larger than a diameter "Dₚ" of the perforated portion 1214 of the showerhead 218. The ring 1212 has a wall thickness "Wᵣ". The ring 1212 is generally the same height H as the bosses 1210. However, the height of the ring 1212 may be varied to accommodate variations in surface geometry of either the mounting portion 1202 or lid assembly 210. The height H, wall thickness Wᵣ and diameter Dᵣ are typically configured to minimize the cross sectional area of the ring 1212.

Generally, the ring 1212 has an aspect ratio (i.e., ratio of the height H to wall thickness Wᵣ greater than zero, and preferably greater than about 0.65. Greater aspect ratios reduce the thermal transfer between the ring 1212 and the lid assembly 210. For example, one embodiment of the showerhead 218 includes a ring 1212 having a height of about 0.25 inches and a wall thickness of about 0.06 inches and has an aspect ratio of 4.16.

The perforated portion 1214 is comprised of a plurality of holes 1316 passing through the showerhead 218. Generally, the holes 1316 are disposed in a polar array within the diameter Dₚ that is greater than the diameter of the substrate 240. The holes 1316 may alternatively be disposed in other patterns or randomly through the perforated portion 1214. The holes 1316 may optionally include a narrow diameter section 1318 and a wider diameter section 1320. The narrow diameter section 1318 is typically open to the second side 1302 of the showerhead 218 while the wider diameter section 1320 is typically open to the first side 1206. The number of holes 1316 and the hole diameters are typically selected to provide flow uniformly of gases passing through the showerhead 218. In one embodiment, the perforated portion comprises about 13,200 holes 1316.

Various structures and configurations enable temperature control between the showerhead 218 and the lid 210, for example, the gap 1322 defined by the spaced-apart relation of the showerhead 218 and lid 210. The gap 1322, whose distance may be controlled by the height H of the boss 1210 and ring 1212, prevents solid to solid (*i.e*., metal to metal) contact thus minimizing conduction therebetween. For example, the rate of heat transfer between the showerhead 118 and the lid 110 may be decreased by increasing the height H, thereby reducing the rate of heat transfer passing across the gap 1322. In one embodiment, the height H is 0.25 inches.

Another structure for controlling heat transfer between the showerhead 218 and the lid assembly 210 is provided by the small cross sectional area of the ring 1212 and bosses 1210. The small cross sectional area (relative the area of the mounting portion 1202 that would be in contact with the lid assembly 210 if not for the bosses 1210 and ring 1212) limits the rate of conduction between the showerhead 218 and the lid assembly 210 through the bosses 1210 and ring 1212. For example, the rate of heat transfer between the showerhead 218 and the lid assembly 210 may be decreased by reducing the cross sectional area of the bosses 1210 or ring 1212, or by increasing the aspect ratio of the ring 1212. By way of illustration, the diameter Dᵣ, the wall thickness Wᵣ, the wall thickness W_{b} or a combination thereof may be reduced to impede heat transfer between the showerhead 218 and the lid assembly 210. Alternatively, decreasing the number of bosses 1210 will decrease the effective cross sectional area of the bosses 1210 thereby reducing heat transfer therethrough without changing the wall thickness W_{b} of each boss 1210. Optionally, both the wall thickness W_{b} and the number of bosses 1210 may be decreased to impede heat transfer between the lid assembly 210 and showerhead 218. An example of such a showerhead is disclosed in the previously incorporated and contemporaneously filed United States Patent Application 09/603,117.

Referring primarily to Fig. 2, in operation, the semiconductor substrate 240 is secured to the support assembly 238 by providing a vacuum therebetween. Gaseous components, which in one embodiment may include silane and tungsten hexafluoride, are supplied from a gas panel to the process chamber through mixing block 234 and showerhead 218 to form a gaseous mixture. The outward position of the mounting holes 1306 in the showerhead 218 minimized turbulence within the chamber 202 as the gaseous mixture passes through the showerhead 218, promoting uniform deposition on the substrate 240. The gaseous mixture reacts or decomposes to form a layer of tungsten on the substrate 240.

The temperature at the surface of the chamber walls is controlled using liquid-containing conduits (not shown) that are located in the walls 206 of the system 200. The temperature of the lid assembly 210 is controlled by flowing heat transfer fluid through the channels 404 disposed in the lid 220. Typically, the lid 220 is maintained about 65 degrees Celsius. The temperature of the substrate 240 is controlled primarily by stabilizing the temperature of the support assembly 238. Using thermal control of both the lid assembly 210 and the support assembly 238, the substrate 240 is maintained at a temperature of 250 to 1200 degrees Celsius.

The temperature of showerhead 218 is maintained at a temperature of between about 300 to about 1250 degrees Celsius by minimizing the thermal transfer between the showerhead 218 and the cooled lid assembly 210. The minimized thermal transfer from the showerhead results in the ability to maintain the showerhead 218 at a temperature up to and exceeding about 250 degrees Celsius. The elevated temperature of the showerhead 218 results in less deposited material clogging the holes 1316 through the showerhead 218 and consequently 13 to 4 times the number of substrates to be processed between showerhead cleaning operations.

Although the teachings of the present invention that have been shown and described in detail herein, those skilled in the art can readily devise other varied embodiments that still incorporate the teachings and do not depart from the scope and spirit of the invention.

## Claims

1. A lid assembly for a processing chamber comprising:
a first plate having at least one hole disposed therethrough;
a second plate connected to the first plate; and
a passage defined between the first side of the first plate and the first side of the second plate, the passage coupled to the at least one hole.

2. A lid assembly as claimed in claim 1, wherein the first plate and the second plate are leak-tight.

3. A lid assembly as claimed in claim 1 or claim 2, wherein the first plate and the second plate are connected in a manner which seals the passage to about 200 psi of water.

4. A lid assembly as claimed in any of claims 1 to 3, wherein the passage is at least partially formed in either the first plate or the second plate.

5. A lid assembly as claimed in any of claims 1 to 4, wherein the first plate and the second plate further comprise:
an aperture disposed through the first plate and the second plate.

6. A lid assembly as claimed in claim 5, wherein the passage further comprises:
a portion that substantially circumscribes the aperture.

7. A lid assembly as claimed in claim 5 or claim 6, wherein the passage further comprises:
a portion that substantially circumscribes the aperture at least two or more times.

8. A lid assembly as claimed in any of claims 1 to 7, further comprising:
a showerhead coupled to the second plate.

9. A lid assembly as claimed in claim 8, wherein the showerhead comprises:
a perforated center portion;
a mounting portion circumscribing the perforated center portion and having a first side; and
a ring extending from the first side of the mounting portion.

10. A lid assembly as claimed in claim 9 further comprising:
a plurality of bosses disposed on the first side of the mounting portion; the plurality of bosses radially position to either side of the ring.

11. A lid assembly as claimed in claim 9 or claim 10, wherein the ring further comprises:
an aspect ratio greater than about 0.65.

12. A lid assembly as claimed in any of claims 1 to 11, further comprising:
an adapter coupled to the first plate, the adapter in fluid communication with the second plate via an aperture disposed in the first plate.

13. A lid assembly as claimed in claim 12, wherein the adapter further comprises:
a body having a portion that extends at least partially into a valve coupled to the adapter.

14. A lid assembly as claimed in any of claims 1 to 13, further comprising:
a mixing block at least partially disposed in an aperture, the aperture disposed through the lower and the first plate.

15. A lid assembly as claimed in claim 14, wherein the first plate further comprises:
a slot formed in a top surface of the first plate or the second plate; and
a dowel pin disposed in the slot, the dowel pin coupled to the mixing block.

16. A lid assembly as claimed in claim 14 or claim 15, wherein the second plate further comprises:
a threaded hole having a screw disposed therein, the screw retaining the mixing block in the aperture.

17. A lid assembly as claimed in any of claims 1 to 16, wherein the first plate further comprises:
at least one hole disposed partially through the first plate;
an aperture disposed through the first plate; and
a passage disposed in the first plate fluidly coupling the at least one hole and the aperture.

18. A lid assembly as claimed in any of claims 1 to 17, wherein the first plate further comprises:
a first one hole disposed partially through the first plate;
a second one hole disposed partially through the first plate;
an aperture disposed through the first plate;
a first passage disposed at least partially in the first plate fluidly coupling the first hole and the aperture; and
a second passage disposed at least partially in the first plate fluidly coupling the second hole and the aperture.

19. A lid assembly as claimed in claim 17 or claim 18, wherein the first plate further comprises:
a plug inserted into the passage.

20. A lid assembly as claimed in claim 19, wherein the plug seals the passage seals the passage to about 200 psi of water.

21. A lid assembly as claimed in any of claims 1 to 20, wherein the first plate is coupled to the first plate by melting a foil of aluminum therebetween.

22. A lid assembly for a processing chamber comprising:
a first plate having at least a first hole disposed partially therethrough;
an aperture disposed through the first plate; and
at least a first passage disposed in the first plate fluidly coupling the at least first hole and the aperture.

23. A lid assembly as claimed in claim 22, wherein the first plate further comprises:
a second hole disposed partially through the first plate; and
a second passage disposed at least partially in the first plate fluidly coupling the second hole and the aperture.

24. A lid assembly as claimed in claim 22 or claim 23, wherein the first plate further comprises:
a plug inserted into the passage.

25. A lid assembly as claimed in claim 24, wherein the passage is sealed to about 1xE-9 sccs of helium at 3xE-8 Torr differential.

26. A lid assembly as claimed in any of claims 22 to 25, further comprising:
a second plate connected to the first plate; and
a passage defined between the first plate and the second plate.

27. A lid assembly as claimed in claim 26, wherein the first plate further comprises:
a least one hole disposed therethrough, the hole in fluid communication with the passage.

28. A lid assembly as claimed in claim 26 or claim 27, wherein the first plate is coupled to the first plate by melting a foil of aluminum therebetween.

29. A lid assembly as claimed in any of claims 22 to 28, wherein the adapter further comprises:
a body having a portion that extends at least partially into a valve coupled to the adapter.

30. A lid assembly for a processing chamber comprising:
a first plate;
a second plate;
an aperture disposed through the first plate and the second plate;
at least a first passage defined between the first plate and the second plate fluidly coupled to the aperture; and
a passage defined between the first plate and the second plate.

31. A lid assembly as claimed in claim 30 further comprises:
a showerhead coupled to the second plate; the showerhead having:
a perforated center portion disposed;
a mounting portion circumscribing the perforated center portion and having a first side;
a plurality of bosses extending from the first side of the mounting portion; and
a ring disposed on the first side of the mounting portion; the ring radially position to either side of the bosses.
